# EUROPEAN PATENT APPLICATION

(11) **EP 0 593 279 A2**
(43) Date of publication of application: **20.04.1994**
(21) Application number: 93308157.2
(22) Date of filing: 13.10.1993
(51) Int. Cl.: H04N 7/00

(54) **Television signal transmitting system and processing apparatus**

(30) Priority: 13.10.1992 JP 273999/92
(71) Applicant: MATSUSHITA ELECTRIC INDUSTRIAL CO., LTD., Kadoma-shi, Osaka-fu, 571 (JP)
(72) Inventor: Hayashi, Kenichiro, Katano-shi, Osaka-fu 576 (JP); Kageyama, Sadashi, Hirakata-shi Osaka-fu 573 (JP); Uwabata, Hideyo, Hirakata-shi, Osaka-fu 573 (JP); Bowser, Todd S., Itami-shi, Hyogo-ken 664 (JP); Yasumoto, Yoshio, Nara-shi, Nara-ken 631 (JP)
(74) Representative: Rackham, Stephen Neil

(57) **Abstract**

Picture images which have an aspect ratio of 4:3 or larger are transmitted as main signals (M1 to M180) in a central main panel of the picture frame of a conventional system. A processing operating using the correlation of vertically adjacent scanning line signals is applied with respect to signals based on a wide television system for transmitting helper or reinforcement signals (S1 to S60) for improving the picture quality of the main signal and providing these signals in upper and lower panels. Cross talk caused between the main signals and the helper signals located in the upper and lower panels next to the main panel cause degradation of the picture quality. The present invention prevents cross talk from being caused, or makes its influence on the picture quality inconspicuous. The transmission system locates a signal (S30, S31) having a large correlation with the helper signal between the main panel, and the upper and lower panel or locates a signal (S1, S60) at the locations next to the main panel so that any picture degradation generated by cross talk is hidden by the over-scans of the display apparatus.

## Description

The present invention generally relates to a wide television signal transmitting method capable of transmitting images of high picture quality images with an aspect ratio of 4 to 3 or larger, while retaining compatibility with the existing television signal transmission system, where an aspect ratio of a NTSC method, a PAL method or the like and so on is 4 to 3, and to a signal processing apparatus for the wide television signal transmitting method.

There is a so called letter box method among wide television signal transmitting methods for retaining compatibility with the existing television signal transmitting method. In the case of, for example, a NTSC method, a main signal of 16 to 9 in aspect ratio is transmitted with the use of approximately 180 scanning lines (hereinafter this portion is referred to as main panel) in the middle portion of the picture among approximately 240 effective scanning lines per field. Some helper signals are proposed to be transmitted with the use of approximately 60 scanning lines, where images are absent (hereinafter the portion is referred to as upper and lower panels), per field to be caused vertically at this time. For example, a horizontal high frequency component, a vertical high frequency component, a vertical - temporal high frequency component or the like of an image is regarded as such a helper signal. On a receiving side, the picture quality is made higher by addition of a transmitted helper signal to a main signal. (For example, SMPTE J., 100 : 104 - 110, Feb. 1991, and SMPTE J., 101 : 790 - 796, Nov. 1992, or NAB HDTV World Conference Proceedings, May 1992).

These helper signals are sequentially allocated on the upper and lower panels from the top of the picture to the bottom of it in correspondence with the main signals. Helper signals which are allocated in a portion in contact with a main panel in the lowermost position of the upper panel, and at a portion in contact with a main panel in the uppermost position of the lower panel correspond to main signals in the middle portion of the main panel in the vertical direction.

When a calculation processing operation using correlation of vertically adjacent scanning line signals as in, for example, line-comb Y / C separation is effected with respect to such wide television signals, some cross talk is caused between the two types of signals, because there is little correlation between the helper signals at the bottom of the upper panel and the top of the lower panel and the main signals at the top and bottom of the main panel. When the helper signal in which cross talk is generated is added to the main signal, the picture quality is degraded in the middle portion of the picture face.

Accordingly, an object of the present invention is to provide a wide television signal transmitting method and a signal processing apparatus for it where the image on the picture face is not degraded as a result of cross talk developing between the main signals and the helper signals.

According to a first aspect of this invention, a television signal processing apparatus for transmitting a television signal, the signal comprising main signals corresponding to an image, the image having an aspect ratio greater than the 4:3 aspect ratio of a conventional television picture, and the image forming a middle main panel of a conventional television picture, and helper signals which improve the quality of the image, and which form upper and lower panels of the conventional television picture comprising an analog to digital converter for converting analog video signals to be inputted into digital signals, a main signal processing circuit for generating main signals from the digital video signals the analog to digital converter outputs, a helper signal processing circuit for generating helper signals from the digital video signals the analog to digital converter outputs, a signal allocating circuit for allocating main signals, which the main signal processing circuit outputs, onto the main panel in the middle of the picture and allocating onto the upper and lower panels the helper signals the helper signal processing circuit outputs, and a digital to analog converter for converting into analog signals the digital television signals the signal allocating circuit outputs.

According to a second aspect of this invention, a television signal processing apparatus for transmitting a television signal, the signal comprising main signals corresponding to an image, the image having an aspect ratio greater than the 4:3 aspect ratio of a conventional television picture, and the image forming a middle main panel of a conventional television picture, and helper signals which improve the quality of the image, and which form upper and lower panels of the conventional television picture comprising a first switch for outputting to a first output when wide television signals to be inputted are helper signals of the upper and lower panels, and for outputting to a second output when the wide television signals to be inputted are the main signals of the main panel, a line-comb Y / C separation filter for separating the second output of the first switch into a luminance signal and a chrominance signal with the use of the correlation of the vertically adjacent scanning line signals, and outputting the luminance signal into the first output and the chrominance signal into the second output, a second switch for selecting either the output of the first output of the first switch when the first switch is interlocked and the wide television signal being input is the helper signals of the upper and the lower panels, or the first output of the line-comb Y / C separation filter and the wide television signals being input are the main signals of the main panel, a luminance signal processing circuit for effecting a luminance signal processing operation with respect to the output of the second switch, and a chrominance signal processing circuit for effecting a chrominance signal processing operation with respect to the second output of the line-comb Y / C separation filter.

According to a third aspect of this invention, a television signal transmitting system where picture images having an aspect ratio greater than 4:3 are transmitted as main signals with the image forming central main panel of a conventional television picture, and helper signals which improve the picture quality of the image, and which form upper and lower panels of the conventional television picture, comprising the steps of locating on the penultimate upper panel scanning line helper signals that are the same as helper signals to be located on the lowermost scanning line of the upper panel, and locating on the second scanning line of the lower panel helper signals that are the same as the helper signals to be located on first scanning line of the lower panel.

According to a fourth aspect of this invention, a television signal transmitting system where picture images having an aspect ratio greater than 4:3 are transmitted as main signals with the image forming central main panel of a conventional television picture, and helper signals which improve the picture quality of the image, and which form upper and lower panels of the conventional television picture, comprising the step of locating the helper signals corresponding to uppermost and lowermost portions of the main panel in the lowermost position of the upper panel and the uppermost position of the lower panel respectively, so that any cross talk developed in these helper signals is not visible as it is hidden in the over scanned portion of a wide television receiver.

Particular embodiments of the present invention will now be described with reference to the accompanying drawings, in which:
Fig. 1 is a block diagram showing the construction of a first embodiment of the television signal processing apparatus of the present invention;
Fig. 2 is a model chart showing a first example of a signal allocation to be transmitted by the television signal transmitting system in accordance with the present invention;
Fig. 3 is a model chart showing a second example of a signal allocation to be transmitted by the television signal transmitting system in accordance with one of the present invention outputs;
Fig. 4 is a model chart showing a third example of a signal allocation to be transmitted by the television signal transmitting system in accordance with the present invention; and,
Fig. 5 is a block diagram showing the construction of a second embodiment of the television signal processing apparatus of the present invention.

Before the description of the present invention proceeds, it is to be noted that like parts are designated by like reference numerals throughout the accompanying drawings.

A television signal transmission system according to the present invention will be described hereinafter with the use of the drawings. Assume that the number of effective scanning lines per field is 240 by way of a NTSC system as the existing television signal transmission system.

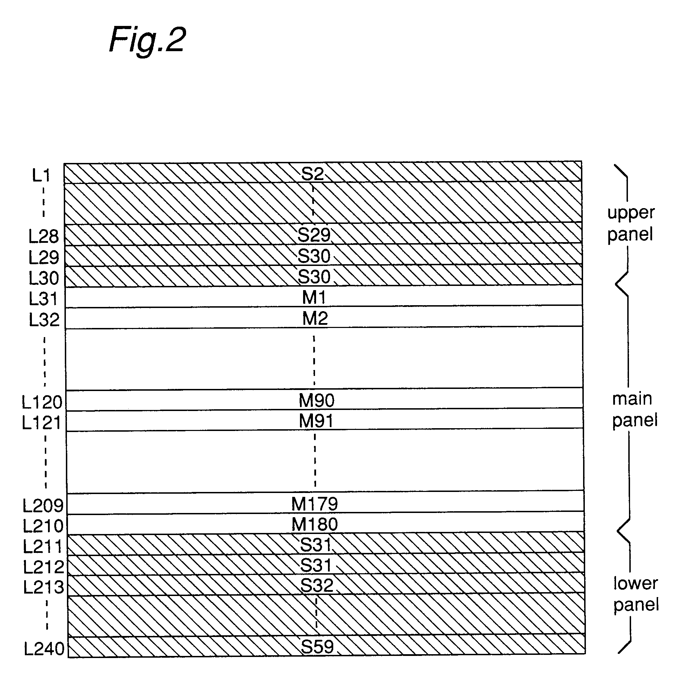

A square external frame in Fig. 2 through Fig. 4 is composed of 240 scanning lines per field, and shows a picture frame in the existing television signal transmission system where an aspect ratio is 4 : 3. Main signals are transmitted with the use of 180 scanning lines (white portion in Fig. 2) of the main panel, and helper signals for improving the picture quality of main signals with the use of 60 scanning lines (hatching portions in Fig. 2) in total of upper and lower panels combined.

In Fig. 2 through Fig. 4, reference characters L1 through L240 on the left side outside of the frame show the numerals of the scanning lines, reference characters M1 through M180 within the frame show the numerals of the main signals to be transmitted by the scanning lines, and reference characters S1 through S60 within the frame show the numerals of the helper signals to be transmitted by the scanning lines. Assume that the helper signal S1 corresponds to the main signals M1 through M3 at this time. The helper signal S2 corresponds to the main signals M4 through M6. The helper signal S60 corresponds to the main signals M178 through M180.

In Fig. 2, the helper signal S1 is removed on the transmission side. The helper signals S2 through S30 are sequentially disposed from the upper position on the picture face on the scanning lines L1 through L29 of the upper panel and the S30 is located again continuously to it. When a processing operation using the correlation of the scanning lines signal vertically adjacent is applied upon the television signal disposed in this manner, a cross talk is caused because of extremely small correlation between the helper signal S30 transmitted by the scanning line L30 and the main signal M1 transmitted by the scanning line L31. As the helper signal S30 transmitted by the scanning line L29 correlates with the helper signal transmitted by the scanning line L30, little cross talk is caused so that the signals are not damaged. The S30 transmitted by the scanning line L29 on the receiving side is added to the main signal and the S30 transmitted by the scanning line L30 is not used so that the degradation of the picture quality in the picture face central portion can be prevented. similarly, the helper signal S60 is not used on the transmission side, and a helper signal S31 is located on the uppermost scanning line L211 of the lower panel and the scanning line L212 second from the top. Continuously the helper signals S32 through S59 are located sequentially from the upper position on the picture face. The helper signal S31 transmitted by the scanning line L211 is removed on the receiving side. The helper signal S31 transmitted by the scanning line L212 is added to the main signal so as to prevent the picture quality degradation in the picture face central portion.

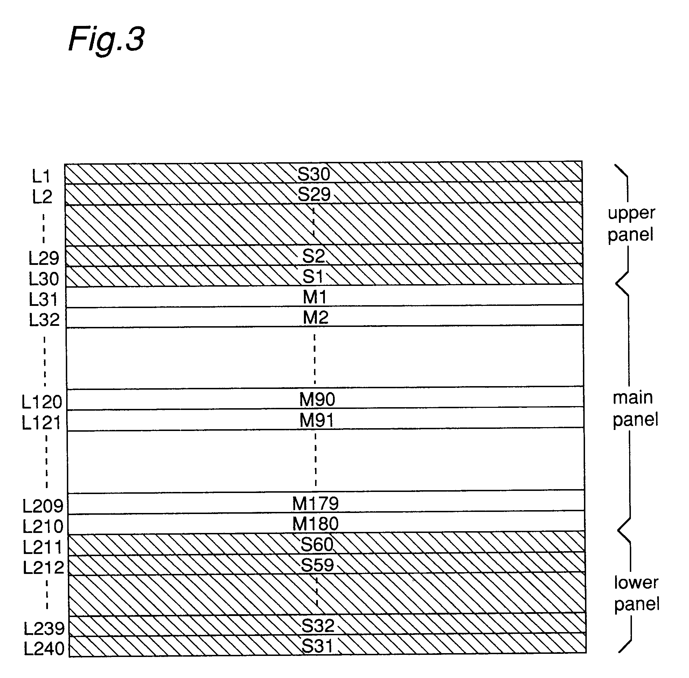

In Fig. 3, the helper signals S1 through S30 are located sequentially from the lower position on the picture face on the scanning lines L1 through L30 of the upper panel and the helper signals S31 through S60 are located sequentially from the lower position on the picture face on the scanning lines L211 through L240 of the lower panel. When the correlation of the vertically adjacent scanning line signals is applied upon the television signal located in this manner, the crosstalk is caused between the helper signal S1 to be transmitted by the scanning line L30 and the main signal M1 to be transmitted by the scanning line L31. As the helper signal S1 corresponds to the main signals M1 through M3, the picture quality degradation can be concealed in the over-scan portion of the displaying apparatus on the receiving side by the addition of the helper signal S1 to the main signal. The above description is also similar about the helper signal S60 transmitted by the scanning L211 of the lower panel.

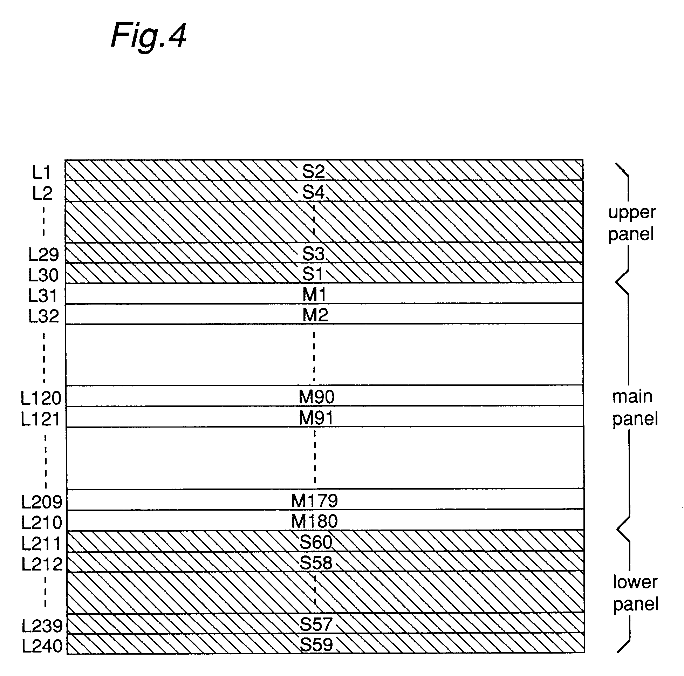

In Fig. 4, on the scanning lines L1 through L30 of the upper panel, a locating operation is effected in a sequential order in that the helper signal S1 is disposed upon the scanning line L30, the helper signal S2 is disposed upon the scanning line L1, the helper signal S3 is disposed upon the scanning line L29, the helper signal S4 is disposed on the scanning line L2. When the processing operation using the correlation of the scanning line signals vertically adjacent is applied upon the television signals located in this manner, the picture quality degradation to be caused not only by the crosstalk to be caused between the helper signal S1 to be transmitted by the scanning line L30 and the main signal M1 to be transmitted by the scanning line L31, but also by the crosstalk to be caused between the helper signal S2 to be transmitted by the scanning line L1 and the scanning line signal of the vertical fly-back line period can be hidden in the portion of the over-scanning of the displaying apparatus on the receiving side. The above description is similar even to the helper signal S59 to be transmitted by the scanning line L240 of the lower panel and the helper signal S60 to be transmitted by the scanning line L211.

An apparatus for generating television signals having such signal location as described hereinabove will be described hereinafter with the use of the drawings.

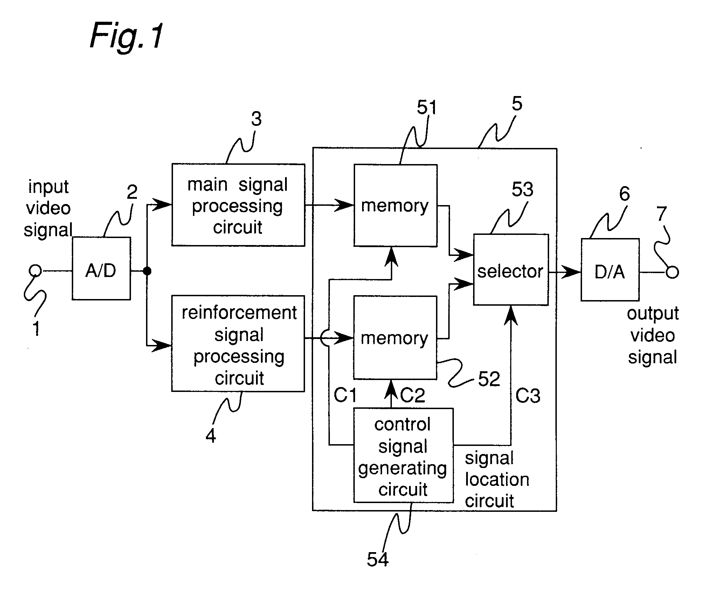

Fig. 1 shows the construction of a television signal processing apparatus in a first embodiment of the present invention. The input terminal 1 is connected with an input of the analog to digital converter 2. An output of the analog to digital converter 2 is connected to an input of the main signal processing circuit 3 and with an input of the helper signal processing circuit 4. An output of the main signal processing circuit 3 is connected to the first input of the signal location circuit 5. An output of the helper signal processing circuit 4 is connected with a second input of the signal location circuit 5. The output of the signal location circuit 5 is connected with the input of the digital to analog converter 6. The output of the digital to analog converter 6 is connected with the output terminal 7.

The operation of the television signal processing apparatus in the first embodiment of the present invention shown in Fig. 1 will be described hereinafter. The analog to digital converter 2 in Fig. 1 converts analog video signals inputted from the input terminal 1 into digital signals. The main signal processing circuit 3 and the helper signal processing circuit 4 respectively separate, generate the main signals and the helper signals from the converted digital video signals. The signal locating circuit 5 relocates the separated and generated main signals and the helper signals in the desired positions. The digital to analog converts the digital video signal relocated into analog signals and outputs from the output terminal 7.

The construction and the operation of the interior of the signal location circuit 5 in Fig. 1 will be described hereinafter. In Fig. 1, a first input of the signal location circuit 5 is connected with a first input of the memory 51. A second input of the signal location circuit 5 is connected with the first input of the memory 52. The output of the memory 51 is connected with the first input of the selector 53. The output of the memory 52 is connected with a second input of the selector 53. The first output of the control signal generating circuit 54 is connected with the second input of the memory 51. The second output of the control signal generating circuit 54 is connected with the second input of the memory 52. A third output of the control signal generating circuit 54 is connected with a third input of the sector 53. The output of the selector 53 is connected with the output of the signal location circuit 5.

In Fig. 1, the memory 51 retains the main signal the main signal processing circuit 3 outputs, and outputs in an inputted order by a first control signal C1 to be outputted from the control signal generating circuit 54. The memory 52 retains a helper signal to be outputted by the helper signal processing circuit 4, and outputs with a desired order and a timing by a second control signal C2 to be outputted from the control signal generating circuit 54. The selector 53 locates on a main panel a main signal the memory 51 outputs, and on the upper and lower panels a helper signal the memory 52 outputs by a third control signal C3 to be outputted from the control signal generating circuit 54.

A first television signal processing apparatus using the present invention shown in Fig. 1 can locate helper signals on the upper and lower panels in an optional order by these constructions.

An apparatus which applies the processing operation using the correlation of the vertically adjacent scanning line signals, without causing unnecessary crosstalks which become factors of the picture quality degradation, with respect to the television signals where contrivances are not effected in such an arrangement as described hereinabove so far will be described hereinafter with reference with the drawings.

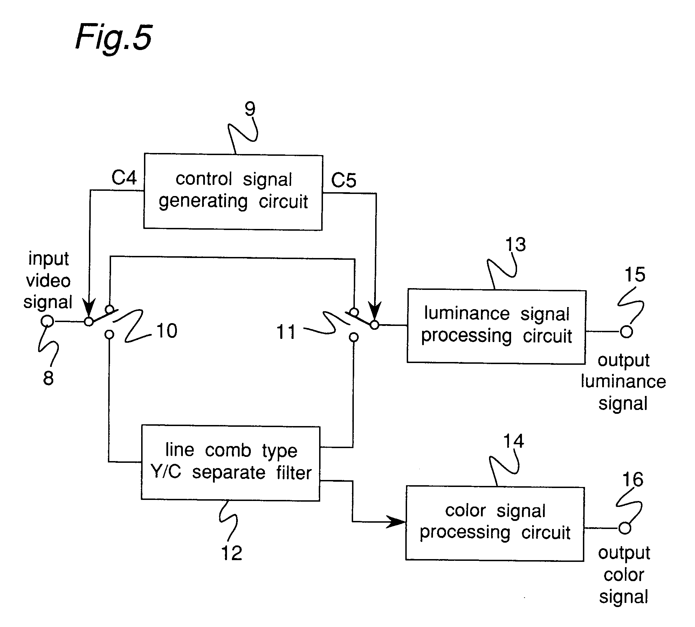

Fig. 5 shows a construction of a television signal processing apparatus in a second embodiment of the present invention. The input terminal 8 is connected with the first input of the switch 10. The first output of the switch 10 is connected with the first input of the switch 11. The second output of the switch 10 is connected with the input of a line comb type Y / C separation filter 12. The first output of line comb type Y / C separation filter 12 is connected with a second input of the switch 11. The second output of the line comb type Y / C separation filter 12 is connected with the input of the chrominance signal processing circuit 14. The output of the switch 11 is connected with the input of the luminance signal processing circuit 13. The first output of the control signal generating circuit 9 is connected with a second input of the switch 10. The second output of the control signal generating circuit 9 is connected with a third input of the switch 11. The output of the luminance signal processing circuit 13 is connected with the luminance signal output terminal 15. The output of the chrominance signal processing circuit 14 is connected with the signal chrominance signal output terminal 16.

An operation of a television signal processing apparatus in a second embodiment of the present invention shown in Fig. 5 will be described hereinafter. A switch 10 switches a route of a signal by a first control signal C4 to be outputted from the control signal generating circuit 9. A switch 11 switches a route of a signal by a second control signal C5 to be outputted from the control signal generating circuit 9. Signals to be inputted from the input terminal 8 are outputted into the luminance signal processing circuit 13 directly when they are helper signals to be transmitted with scanning lines of upper and lower panels. When they are main signals transmitted with the scanning lines of the main panel, they are separated into luminance signals and chrominance signals by the line-comb Y / C separation filter 12 and are respectively outputted into the luminance signal processing circuit 13 and the chrominance signal processing circuit 14. The luminance signal processing circuit 13 and the chrominance signal processing circuit 14 apply a unique processing operation respective upon the luminance signal and the chrominance signal, and thereafter, output the luminance signal output terminal 15 and the chrominance signal output terminal 16.

A television signal processing apparatus in the second embodiment of the present invention shown in Fig. 5 outputs it as a luminance signal without applying the line-comb Y / C separation processing with respect to the helper signal of the upper and lower panels. Accordingly, the crosstalk is prevented from being caused between the helper signal and the main signal on the boundary of the upper and lower panel and the main panel.

## Claims

1. A television signal processing apparatus for transmitting a television signal, the signal comprising main signals corresponding to an image, the image having an aspect ratio greater than the 4:3 aspect ratio of a conventional television picture, and the image forming a middle main panel of a conventional television picture, and helper signals which improve the quality of the image, and which form upper and lower panels of the conventional television picture comprising an analog to digital converter (2) for converting analog video signals to be inputted into digital signals, a main signal processing circuit (3) for generating main signals from the digital video signals the analog to digital converter (2) outputs, a helper signal processing circuit (4) for generating helper signals from the digital video signals the analog to digital converter (2) outputs, a signal allocating circuit (5) for allocating main signals, which the main signal processing circuit (3) outputs, onto the main panel in the middle of the picture and allocating onto the upper and lower panels the helper signals the helper signal processing circuit (4) outputs, and a digital to analog converter (6) for converting into analog signals the digital television signals the signal allocating circuit (5) outputs.

2. A television signal processing apparatus as defined in claim 1, wherein the signal allocating circuit comprises a first memory (51) for retaining main signals and outputting them in an inputted order, a second memory (52) for retaining helper signals and outputting helper signals with a desired order and timing, a selector (53) for allocating the main signals the first memory outputs into the main panel in the middle of a picture frame and allocating helper signals the second memory outputs onto the upper and lower panels so as to output them, and a control signal generator (54) for feeding control signals, a first control signal (C1) for controlling the timing of input and output of the main signals to the first memory (51), a second control signal (C2) for controlling the timing of input and output of the helper signal to the second memory (52), and a third control signal (C3) for controlling the switching of signals to the selector (53).

3. A television signal processing apparatus for transmitting a television signal, the signal comprising main signals corresponding to an image, the image having an aspect ratio greater than the 4:3 aspect ratio of a conventional television picture, and the image forming a middle main panel of a conventional television picture, and helper signals which improve the quality of the image, and which form upper and lower panels of the conventional television picture comprising a first switch (10) for outputting to a first output when wide television signals to be inputted are helper signals of the upper and lower panels, and for outputting to a second output when the wide television signals to be inputted are the main signals of the main panel, a line-comb Y / C separation filter (12) for separating the second output of the first switch (10) into a luminance signal and a chrominance signal with the use of the correlation of the vertically adjacent scanning line signals, and outputting the luminance signal into the first output and the chrominance signal into the second output, a second switch (11) for selecting either the output of the first output of the first switch (10) when the first switch is interlocked and the wide television signal being input is the helper signals of the upper and the lower panels, or the first output of the line-comb Y / C separation filter (12) and the wide television signals being input are the main signals of the main panel, a luminance signal processing circuit (13) for effecting a luminance signal processing operation with respect to the output of the second switch (11), and a chrominance signal processing circuit (14) for effecting a chrominance signal processing operation with respect to the second output of the line-comb Y / C separation filter (12).

4. A television signal transmitting system where picture images having an aspect ratio greater than 4:3 are transmitted as main signals with the image forming central main panel of a conventional television picture, and helper signals which improve the picture quality of the image, and which form upper and lower panels of the conventional television picture, comprising the steps of locating on the penultimate upper panel scanning line (L29) helper signals (S30) that are the same as helper signals (S30) to be located on the lowermost scanning line (L30) of the upper panel, and locating on the second scanning line (L212) of the lower panel helper signals (S31) that are the same as the helper signals (S31) to be located on first scanning line (L211) of the lower panel.

5. A television signal transmitting system where picture images having an aspect ratio greater than 4:3 are transmitted as main signals with the image forming central main panel of a conventional television picture, and helper signals which improve the picture quality of the image, and which form upper and lower panels of the conventional television picture, comprising the step of locating the helper signals (S1, S60) corresponding to uppermost and lowermost portions of the main panel in the lowermost position (L30) of the upper panel and the uppermost position (L211) of the lower panel respectively, so that any cross talk developed in these helper signals (S1, S60) is not visible as it is hidden in the over scanned portion (M1, M180) of a wide television receiver.

6. A television signal transmitting system according to claim 5, comprising the further step of locating the helper signals (S2, S59) corresponding to other upper and lower portions of the main panel in the uppermost position (L1) of the upper panel and the lowermost position (L240) of the lower panel respectively, so that any cross talk developed in these helper signals (S2, S59) is not visible as it is hidden in the over scanned portion (M1, M2, M179, M180) of a wide television receiver.

7. A television signal transmitting system where picture images having an aspect ratio larger as compared with an existing television signal transmitting system where an aspect ratio is 4 : 3 are transmitted as main signals with a central main panel of a picture frame of the existing system, helper signals for improving the picture quality of the main signals are transmitted with upper and lower panels to be caused at this time, comprising a step of corresponding the helper signals located in the uppermost position of the upper panel and the lowermost position of the lower panel to main signals located on the main panel of the portion hidden with over-scans in a wide television receiving machine.
